# FASCICULE DE BREVET EUROPEEN

(11) **EP 0 743 650 B1**
(45) Date de publication et mention de la délivrance du brevet: **25.07.2001**
(21) Numéro de dépôt: 96401080.5
(22) Date de dépôt: 15.05.1996
(51) Int. Cl.: G11C 16/06, G11C 7/00

(54) **Circuit de détection de courant pour la lecture d'une mémoire en circuit intégré**
Stromdetektorschaltung zum Lesen einer integrierten Speicherschaltung
Current detector circuit for reading integrated circuit memory

(30) Priorité: 19.05.1995 FR 9506008
(43) Date de publication de la demande: 20.11.1996
(73) Titulaire: STMicroelectronics S.A., 94250 Gentilly (FR)
(72) Inventeur: Yero, Emilio, 94230 Cachan (FR)
(74) Mandataire: Schmit, Christian Norbert Marie

(56) Documents cités:
- US-A- 5 305 273
- US-A- 5 390 147
- IEEE INTERNATIONAL SOLID STATE CIRCUITS CONFERENCE, vol. 34, Février 1991, NEW YORK US, pages 264-265, XP000238333 SWEHA ET AL: "A 29ns 8Mb EPROM with dual refererence-column ATD sensing"

## Description

L'invention concerne un circuit de détection de courant pour la lecture d'une mémoire en circuit intégré. L'invention s'applique tout particulièrement, mais pas exclusivement, aux mémoires électriquement programmables, dont la cellule de base est un transistor à grille flottante (EPROM, E²PROM, flash EPROM).

On rappelle que les cellules des mémoires en circuit intégré sont agencées matriciellement. Une ligne de mot commande (directement ou par l'intermédiaire de transistors de sélection) les grilles des cellules situées sur une même rangée. L'état d'une cellule est lu sur une ligne de bit reliée aux drains des cellules situées avec cette cellule sur une même colonne.

Quand on veut lire une cellule mémoire, on fournit son adresse à un décodeur de la mémoire qui sélectionne la rangée correspondante pour appliquer une tension de lecture sur la grille de la cellule et qui sélectionne la colonne correspondante pour la connecter à un dispositif de lecture.

Ce dispositif de lecture comprend classiquement un circuit de détection de courant connecté en entrée à la colonne et qui fournit en sortie un niveau de tension variant fortement avec le courant d'entrée. De manière simplifiée, si la cellule sélectionnée est faiblement passante, la tension en sortie du détecteur sera grande. Si la cellule est fortement passante, cette tension de sortie sera faible. Cette tension de sortie est appliquée à un circuit de lecture, qui fournit l'information binaire. Le dispositif de lecture comprend aussi un élément de précharge (résistance ou transistor) qui est activé dès la détection d'un changement d'adresse, pour injecter du courant dans le circuit de détection de courant. De cette manière, on force la ligne de bit (capacitive) à une tension de précharge ce qui permet de diminuer le temps d'accès en lecture.

Dans la présente invention, on s'intéresse plus particulièrement à une mémoire du type à cellule de référence de lecture. Un circuit de détection de courant de référence est associé à une cellule de référence. Le circuit de lecture comprend dans ce cas un amplificateur différentiel qui reçoit sur une entrée, la sortie du détecteur de courant de référence et sur l'autre entrée, la sortie du détecteur de courant d'une colonne sélectionnée.

Un problème lié au caractère différentiel de la lecture est l'équilibrage des différentes branches. Notamment, une structure en miroir de courant est prévue entre une source de courant reliée à la sortie du circuit de détection de courant de référence, et la sortie du circuit de détection de courant sur une colonne. En outre, on peut prévoir d'associer un circuit de précharge au circuit de référence, pour améliorer encore l'équilibrage.

Les développements récents dans le domaine des mémoires en circuit intégré concernent notamment l'utilisation de faibles alimentations externes. Le circuit mémoire doit alors comporter des circuits de génération interne des niveaux de tension logique nécessaires au fonctionnement de la mémoire. Un élément de base de ces circuit de génération est le multiplieur de tension.

Comme par ailleurs, on cherche à accéder le plus rapidement possible aux mémoires, ces circuits de génération interne sont dimensionnés pour avoir un fort gain en tension.

Il est apparu que ces circuits de génération interne des tensions logiques pouvaient entraîner un niveau de précharge plus important, du fait de pics de tensions logiques. Cette précharge plus importante entraîne un courant important dans la colonne sélectionnée, ce qui fait basculer l'inverseur du circuit de détection de courant associé. Cela impose une consigne de tension de blocage sur le transistor du détecteur : la sortie du détecteur passe en haute impédance, c'est à dire que la colonne est temporairement déconnectée du circuit de lecture. Comme il n'y a pas de courant sur l'entrée du circuit de lecture, ce dernier interprète l'entrée comme un zéro. On perd tout l'avantage de la précharge qui consiste justement à prépositionner le circuit de lecture à une valeur intermédiaire, de manière à avoir l'information binaire le plus rapidement possible en sortie.

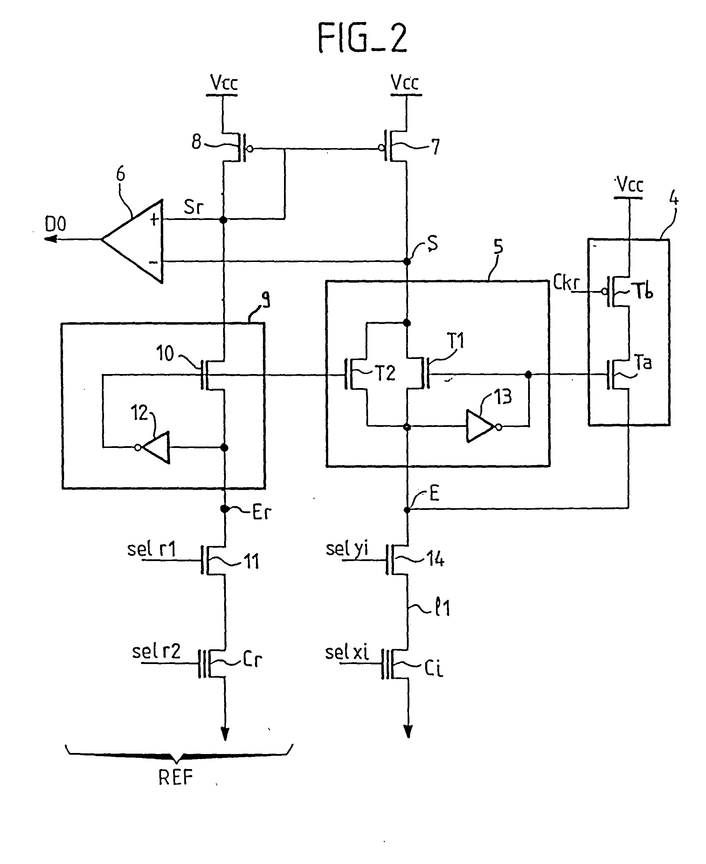

US-A-5 390 147 décrit une mémoire selon l'état de la technique. Dans cette mémoire on cherche d'éviter ce problème par la génération d'un courant (I_{LUBE}, fig.2) qui tient le transistor de détection de courant (331) ouvert.

Un objet de l'invention est d'empêcher que la connexion entre le circuit de lecture et la colonne sélectionnée soit ouverte.

Dans l'invention, on prévoit un dispositif de contrôle de la consigne de commande du transistor du détecteur de courant, pour empêcher le blocage dudit transistor.

Un autre problème apparaît alors, qui est le maintien de l'équilibrage du circuit de lecture entre le circuit de détection de courant de référence et celui de la colonne sélectionnée.

L'idée de l'invention est d'utiliser le détecteur de courant de référence pour forcer le passage entre l'entrée et la sortie du circuit de détection de courant.

Telle qu'elle est caractérisée, l'invention concerne une mémoire en circuit intégré, organisée matriciellement en lignes et colonnes comprenant au moins une cellule de référence de lecture associée à un circuit de détection de courant de référence. Un circuit de détection de courant est connecté en entrée à au moins une colonne de la mémoire et en sortie à l'autre entrée du comparateur. Selon l'invention, ce circuit de détection de courant comprend un transistor connecté entre l'entrée et la sortie et commandé sur sa grille par le circuit de détection de courant de référence.

L'invention sera mieux comprise à la lecture de la description suivante, faite à titre indicatif et non limitatif de l'invention, en référence aux dessins annexés, dans lesquels :
- la figure 1 représente un exemple d'architecture d'une mémoire en circuit intégré,
- la figure 2 représente un dispositif de lecture selon l'invention associé à une colonne d'une mémoire en circuit intégré avec circuit de référence de lecture.

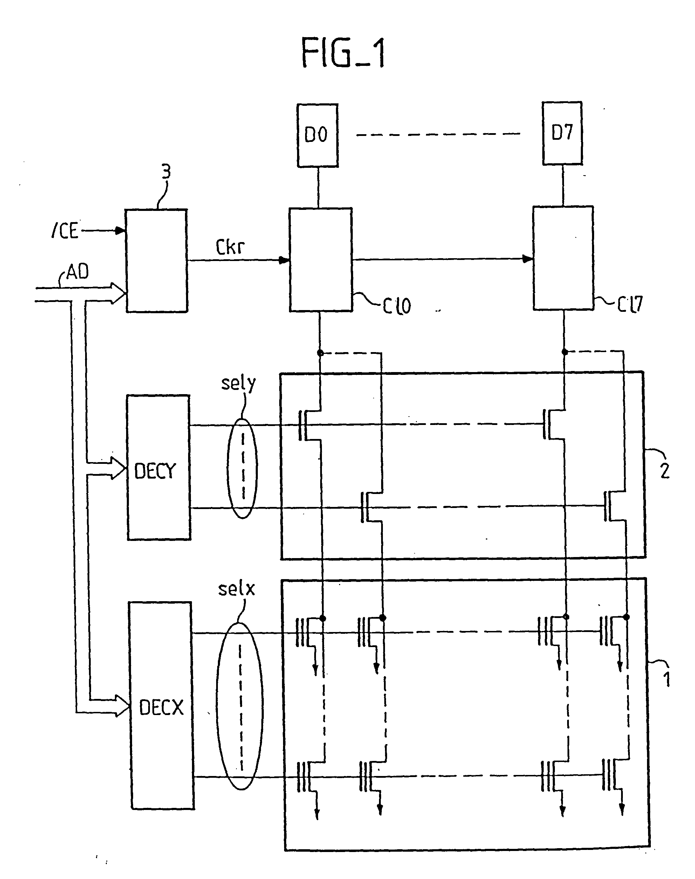

Sur la figure 1, on a représenté un plan de cellules mémoires 1 agencé matriciellement en rangées et colonnes, un circuit porte 2 commandé par un décodeur de ligne de bit DECY pour sélectionner (sely) une ou plusieurs colonnes (huit dans l'exemple) et les relier chacune à un dispositif de lecture associé C10, ..., C17.

Le plan mémoire est par ailleurs contrôlé par un décodeur de rangées DECX pour sélectionner (selx) une rangée.

Un circuit de détection de transitions d'adresse 3 qui reçoit les signaux de sélection de la mémoire /CE, et du bus d'adresse AD, fournit un signal de déclenchement Ckr des dispositifs de lecture (C10, ..., C17), dès la détection d'une nouvelle adresse.

Un dispositif de lecture associé à au moins une colonne l1 de la mémoire est détaillé à la figure 2. Il comprend un circuit de précharge 4, un détecteur de courant 5 et un circuit de lecture 6.

Dans l'exemple, le circuit de précharge 4 comprend un transistor MOS Ta de type N, dont le drain est connecté à la tension d'alimentation logique Vcc via un interrupteur Tb et dont la source est connectée à l'entrée E du détecteur de courant 5. La grille du transistor Ta est commandée par le détecteur de courant 5. L'interrupteur Tb est lui commandé par le signal de déclenchement Ckr. Dans l'exemple, l'interrupteur Tb est un transistor MOS de type N.

Le détecteur de courant 5 est connecté en entrée E à au moins la colonne l1 par un transistor 14 du circuit porte 2 de la figure 1. L'entrée E du détecteur de courant est alors activement connectée à une colonne l1 sélectionnée par ce transistor 14, commandé par un signal selyi du décodeur de colonnes DECY (figure 1). Les autres colonnes, éventuellement connectées à cette même entrée E, sont nécessairement désélectionnées.

Le circuit de lecture 6 comprend classiquement un amplificateur différentiel recevant sur une entrée un signal de référence Sr, l'autre entrée étant connectée à la sortie S du détecteur de courant. Il délivre en sortie un signal binaire vers une broche d'entrée/sortie de la mémoire en circuit intégré.

Le dispositif de lecture est par ailleurs associé à un circuit de référence REF. Ce circuit de référence comprend une source de courant 8 et un détecteur de courant de référence 9 associé à au moins une cellule de référence Cr. Il pourrait aussi comprendre un circuit de précharge (non représenté).

La source de courant 8 est classiquement un transistor monté en diode. Dans l'exemple, c'est un transistor MOS de type P, dont la grille est connectée au drain et dont la source est connectée à la tension d'alimentation Vcc. Cette source de courant 8 est utilisée dans un montage en miroir de courant avec le dispositif de lecture. Pour cela, la grille d'un transistor 7 est reliée à la grille du transistor 8 du circuit de référence REF. Ce transistor 7 est connecté entre la tension d'alimentation et la sortie S du circuit 5 de détection de courant. Cette structure en miroir de courant permet d'obtenir dans chaque branche de détection de courant, un courant calibré par le rapport de géométrie entre ces deux transistors. Ceci permet un bon équilibrage de l'amplificateur différentiel de lecture.

Le détecteur de courant de référence 9 comprend classiquement un transistor 10, dans l'exemple de type MOS N. Le drain est connecté en sortie Sr du détecteur au drain du transistor 8 8 et la source est connectée en entrée Er au drain de la cellule de référence Cr, éventuellement via un interrupteur 11. Enfin, un inverseur 12 est connecté entre la source et la grille du transistor 10. Un circuit de précharge pourrait aussi être prévu, toujours dans le but de bien équilibrer les entrées de l'amplificateur différentiel. Mais il n'a pas été représenté ici, pour simplifier l'exposé.

Ce montage bien connu pour la détection de courant constitue un asservissement établissant sur l'entrée Er du détecteur 9 une tension de précharge liée aux caractéristiques technologiques du transistor 10 et de l'inverseur 12.

Si une cellule Ci de la colonne l1 est sélectionnée en lecture (selxi), une tension de lecture correspondante est appliquée sur sa grille (de l'ordre de 5 volts pour une cellule flash EPROM). Le circuit de référence REF est sélectionné (signaux selr1 et selr2 appliqués respectivement sur l'interrupteur l1 et la cellule de référence Cr). Le signal de déclenchement Ckr est généré. Le circuit de précharge 4 fournit alors un courant d'injection vers l'entrée du détecteur de courant 5 qui asservit la colonne sélectionnée (l1) à une tension de précharge. La cellule Ci fournit un certain courant, fonction de son état programmé ou non, qui fait réagir le détecteur 5. Une tension s'établit en sortie S du détecteur 5, comparée à la référence de tension Sr fournie par le circuit de référence REF, par le comparateur 6 qui fournit en sortie l'information binaire 0 ou 1 correspondante. Cette information binaire est transmise vers la broche D0.

Selon l'invention, le détecteur de courant 5 du dispositif de lecture, qui a habituellement la même structure et les mêmes caractéristiques d'asservissement que celles du détecteur de courant de référence 9 9 décrit plus haut, comprend en outre un transistor T2 commandé par le circuit de référence REF.

Dans l'exemple, le détecteur de courant 5 comprend ainsi deux transistors T1 et T2 connectés en parallèle entre son entrée E et la sortie S.

L'un, T1, est commandé sur sa grille de manière classique, par la sortie d'un inverseur 13.

L'autre, T2, est commandé sur sa grille par la grille du transistor 10 du détecteur de courant de référence 9.

De cette manière, le noeud de sortie S du détecteur de courant 5 ne peut plus se trouver en haute impédance, car le transistor T2 permet toujours, pendant toute la lecture, le passage du courant : le passage entre l'entrée E et la sortie S est forcé par le circuit de référence REF.

La colonne ne risque plus d'être temporairement déconnectée du circuit de lecture et on n'a donc plus de fausses lectures de zéro.

En pratique, les transistors T1 et T2 sont dimensionnés en sorte qu'ils soient équivalents au transistor 10 du circuit de référence.

L'invention s'applique aussi bien aux détecteurs utilisant plusieurs transistors de seuils différents commandés par la sortie de l'inverseur (accélération de la charge de la capacité de ligne de bit). L'invention consiste à séparer l'un d'eux en deux transistors, dont l'un sera commandé par le détecteur de courant de référence.

## Revendications

1. Mémoire en circuit intégré organisée matriciellement en lignes et colonnes comprenant au moins une cellule de référence de lecture (Cr) associée à un circuit de détection de courant de référence (9) pour délivrer un signal de référence (Sr) sur une entrée d'un comparateur (6), un circuit de détection de courant (5) étant connecté en entrée (E) à au moins une colonne (l1) de la mémoire et en sortie (S) à l'autre entrée du comparateur, caractérisé en ce que ledit circuit de détection de courant (5) comprend un premier transistor (T2) connecté entre l'entrée E et la sortie (S) et commandé sur sa grille par ledit circuit de détection de courant de référence.

2. Mémoire en circuit intégré selon la revendication 1, le circuit de détection de courant (5) comprenant un inverseur pour commander la grille d'au moins un deuxième transistor (T1) en série entre le point d'entrée (E) et le point de sortie (S), caractérisé en ce que le premier et le deuxième transistors (T1 et T2) ont la même tension de seuil.

3. Mémoire en circuit intégré selon la revendication 1 ou 2, le circuit de détection de référence (9) comprenant un inverseur (12) commandant la grille d'un transistor de référence (10), caractérisé en ce que le premier transistor (T2) a sa grille connectée à la grille dudit transistor de référence.

## Claims

1. Integrated-circuit memory organised as a matrix in rows and columns comprising at least one read-reference cell (Cr) combined with a reference-current detection circuit (9) in order to deliver a reference signal (Sr) on one input of a comparator (6), a current-detection circuit (5) being connected, at its input (E), to at least one column (l1) of the memory and at its output (S) to the other input of the comparator, characterised in that the said current-detection circuit (5) comprises a first transistor (T2) connected between the input (E) and the output (S) and controlled, on its gate, by the said reference-current detection circuit.

2. Integrated-circuit memory according to Claim 1, the current-detection circuit (5) comprising an inverter for controlling the gate of at least one second transistor (T1) in series between the input point (E) and the output point (S), characterised in that the first and second transistors (T1 and T2) have the same threshold voltage.

3. Integrated-circuit memory according to Claim 1 or 2, the reference-detection circuit (9) comprising an inverter (12) controlling the gate of a reference transistor (10), characterised in that the first transistor (T2) has its gate connected to the gate of the said reference transistor.

## Patentansprüche

1. Integrierte Speicherschaltung, die matrixförmig in Zeilen und Spalten aufgeteilt ist, mit wenigstens einer Lesereferenzzelle (Cr), die mit einem Referenzstromdetektorschaltkreis (9) zusammenwirkt, um ein Referenzsignal (Sr) an einem Eingang eines Komperators (6) auszugeben, einem Stromdetektorschaltkreis (5), der am Eingang (E) mit wenigstens einer Spalte (l1) des Speichers am Ausgang (S) mit dem anderen Eingang des Komperators verbunden ist, dadurch gekennzeichnet, daß der Stromdetektorschaltkreis (5) einen ersten Transistor (T2) umfaßt, der zwischen den Eingang (E) und den Ausgang (S) geschaltet ist und über sein Gate durch den Referenzstromdetektorschaltkreis gesteuert wird.

2. Integrierte Speicherschaltung nach Anspruch 1, wobei der Stromdetektorschaltkreis (5) einen Inverter zum Steuern des Gates wenigstens eines zweiten Transistors (T1) in Reihe zwischen dem Eingangspunkt (E) und dem Ausgangspunkt (S) umfaßt, dadurch gekennzeichnet, daß der erste und der zweite Transistor (T1 und T2) den gleichen Spannungsschwellenwert haben.

3. Integrierte Speicherschaltung nach Anspruch 1 oder 2, wobei der Referenzdetektorschaltkreis (9) einen Inverter (12) umfaßt, der das Gate eines Referenztransistors (10) steuert, dadurch gekennzeichnet, daß der erste Transistor (T2) über sein Gate mit dem Gate des Referenztransistors verbunden ist.
